# EUROPEAN PATENT SPECIFICATION

(11) **EP 4 285 415 B1**
(45) Date of publication and mention of the grant of the patent: **28.01.2026**
(21) Application number: 21748827.9
(22) Date of filing: 22.07.2021
(51) Int. Cl.: H10D 8/60, H10D 30/63, H10D 30/67, H10D 62/10, H10D 62/80, H10D 84/00, H10D 84/01, H10D 84/08, H10D 87/00, H10F 71/00, H10F 77/124, H10D 30/87

(54) **TRANSISTOR DEVICE**
TRANSISTORVORRICHTUNG
DISPOSITIF DE TRANSISTOR

(43) Date of publication of application: 06.12.2023
(73) Proprietor: Huawei Technologies Co., Ltd., Shenzhen, Guangdong 518129 (CN)
(72) Inventor: SILVESTRI, Marco, 80992 Munich (DE); CURATOLA, Gilberto, 80992 Munich (DE)
(74) Representative: Gill Jennings & Every LLP
(86) International application number: PCT/EP2021/070466
(87) International publication number: WO 2023/001374

(56) References cited:
- CN-A- 112 951 911
- US-A1- 2010 283 083
- US-A1- 2015 325 660
- US-A1- 2020 111 876
- US-A1- 2020 219 878
- US-A1- 2020 279 939
- MONTES JOSSUE ET AL: "Demonstration of mechanically exfoliated[beta]-Ga2O3/GaN p-n heterojunction", APPLIED PHYSICS LETTERS, AMERICAN INSTITUTE OF PHYSICS, 2 HUNTINGTON QUADRANGLE, MELVILLE, NY 11747, vol. 114, no. 16, 25 April 2019 (2019-04-25), XP012237360, ISSN: 0003-6951, [retrieved on 20190425], DOI: 10.1063/1.5088516
- XU WENHUI ET AL: "First Demonstration of Waferscale Heterogeneous Integration of Ga2O3 MOSFETs on SiC and Si Substrates by Ion-Cutting Process", 2019 IEEE INTERNATIONAL ELECTRON DEVICES MEETING (IEDM), IEEE, 7 December 2019 (2019-12-07), XP033714413, DOI: 10.1109/IEDM19573.2019.8993501
- YUAN CHAO ET AL: "Modeling and analysis for thermal management in gallium oxide field-effect transistors", JOURNAL OF APPLIED PHYSICS, AMERICAN INSTITUTE OF PHYSICS, 2 HUNTINGTON QUADRANGLE, MELVILLE, NY 11747, vol. 127, no. 15, 20 April 2020 (2020-04-20), XP012246244, ISSN: 0021-8979, [retrieved on 20200420], DOI: 10.1063/1.5141332

## Description

### TECHNICAL FIELD

The present disclosure relates generally to the field of semiconductor devices and more specifically, to a member, metal-semiconductor field-effect transistor, MESFET, devices, power devices, and a method for manufacturing the member.

### BACKGROUND

Generally, a semiconductor device is based on electronic properties of a semiconductor material, such as silicon (Si), germanium (Ge), and the like, for its functioning. The semiconductor device is manufactured either as an individual device or as an integrated circuit (IC) device, such as a conventional silicon (Si)-based field-effect transistor (FET). However, due to a narrow bandgap (or energy bandgap) among the conventional Si material and a low electric field, an overall performance of the conventional Si-based FET is reduced. Conventionally, intensive efforts have been taken as a possible replacement of the conventional Si-based FET, such as by development of wide bandgap (WBG) semiconductor materials or by the development of ultrawide bandgap (UWBG) semiconductor materials. Examples of the semiconductor materials having a wide bandgap (WBG) include, but are not limited to, gallium nitride (GaN) with a bandgap of 3.4 electron volt (eV), and silicon carbide (SiC) with a bandgap of 3.3eV. Similarly, examples of the semiconductor materials having ultrawide bandgap (UWBG) include, but are not limited to, gallium oxide (or digallium trioxide, or Ga2O3) with a bandgap of 4.9 eV, diamond with a bandgap of 5.5 eV, and aluminum nitride (AIN) with a bandgap of 6.28 eV. The semiconductor materials with the wide bandgap and the semiconductor materials with the ultrawide bandgap provides improved material properties, like larger energy bandgap, higher critical electric field, and the like. The wide bandgap semiconductor materials provide a partially improved performance both at a device level as well as at a system level, for example, conventional enhancement mode GaN and SiC power FETs are already used by semiconductor manufacturers in various products. Therefore, a significant performance improvement can be expected from the wide bandgap semiconductor materials and the ultrawide bandgap semiconductor materials over the conventional Si-based FETs. The ultrawide bandgap semiconductor materials may provide many figures-of-merit (FOM) for device performance and these FOM scales nonlinearly with the bandgap.

Typically, in high-power electronics, high power is required for power switching and to control an individual application. For example, a conventional wide bandgap semiconductor-material based FET can reduce power switching to a low level, on which heat dissipation and heat sinks will not be encumbered by a system design and can reduce an overall wastage and cost as well. Such semiconductor device can realize a stronger doping under a given breakdown voltage, which reduces the overall electric conduction and power switching. As a result, the efficiency of power transformation of such semiconductor device is increased. Conventionally, stronger doping can be realized for the semiconductor device, such as by using the silicon carbide (or vertical silicon carbide) for high breakdown voltage or by using the gallium nitride for low breakdown voltage. As far as the conventional wide bandgap technology is concerned, usually used approach for mass production of the semiconductor device for different applications is to co-integrate the gallium nitride onto a cheap silicon substrate. However, to achieve high performance semiconductor devices, it is required to co-integrate the ultrawide bandgap technology (e.g., the gallium oxide) with the gallium nitride on to cheap silicon substrate. Moreover, the usage of established gallium nitride on silicon production lines enable faster production of gallium nitride based devices. But due to low thermal conductivity associated with the gallium oxide, it is quite difficult to co-integrate the ultrawide bandgap technology (e.g., the gallium oxide) with the gallium nitride on to cheap silicon substrate. Therefore, due to the low thermal conductivity of the gallium oxide, there exists a technical problem to co-integrate the ultrawide bandgap technology (e.g., the gallium oxide) with the gallium nitride-onto cheap silicon substrate.

CN 112951911 A1 discloses an enhanced GaN-based high electron mobility transistor and preparation method thereof. US 2020/111876 A1 discloses an AlGaN/GaN heterojunction HEMT device compatible with a Si-CMOS process and a manufacturing method therefor. US 2020/279939 A1 discloses transistors including first and second semiconductor materials between source and drain regions, and methods of manufacturing the same. Montes Jossue et al. discloses a demonstration of a mechanically exfoliated β-Ga₂O₃/GaN p-n heterojunction. US 2020/219878 A1 discloses side-by-side integration of III-N transistors and thin-film transistors. US 2015/325660 discloses a crystalline multilayer structure and semiconductor device.

In "First Demonstration of Waferscale Heterogeneous Integration of Ga2O3 MOSFETs on SiC and Si Substrates by Ion-Cutting Process", 2019 IEEE INTERNATIONAL ELECTRON DEVICES MEETING (IEDM), IEEE, 7 December 2019, Xu Wenhui et al. discloses a first demonstration of waferscale heterogenous integration of Ga₂O₃ MOSFETs on SiC and Si substrates by an ion-cutting process.

In "Modeling and analysis for thermal management in gallium oxide field-effect transistors", JOURNAL OF APPLIED PHYSICS, AMERICAN INSTITUTE OF PHYSICS, 2 HUNTINGTON QUADRANGLE, MELVILLE, NY 11747, vol. 127, no. 15, 20 April 2020, Yuan Chao et al. discloses modelling and analysis for thermal management in gallium oxide field-effect transistors comprising an unintentionally doped Ga2O3 layer, a Ga2O3 channel layer and a Ga2O3 barrier layer formed in this order on a semi-insulating Ga2O3 layer.

Therefore, in light of the foregoing discussion, there exists a need to overcome the aforementioned drawbacks associated with the conventional ultrawide bandgap technology.

### SUMMARY

The present disclosure provides a member, transistor devices, power devices, and a method for manufacturing the member. The present disclosure provides a solution to the existing problem to co-integrate the ultrawide bandgap technology (e.g., the gallium oxide) with the gallium nitride-on-silicon technology. An objective of the present disclosure is to provide a solution that overcomes at least partially the problems encountered in the prior art and provides an improved member, transistor devices, power devices, and further an improved method for manufacturing the member that overcomes the problems associated with the conventional ultrawide bandgap technology.

The invention is defined in the enclosed independent claims. Advantageous implementations of the present disclosure are further defined in the dependent claims.

The MESFET device of the present invention comprises a member comprising a silicon base substrate layer, a transition layer arranged over the silicon base substrate layer, and a gallium nitride (GaN) buffer layer arranged over the transition layer, wherein the member further comprises a gallium oxide layer.

The member of the present disclosure implies different properties (e.g., ultrawide bandgap) of the gallium oxide layer such as to achieve benefit of higher electrical performance (e.g., breakdown voltage (BV), figures-of-merit (FOMs)) for power semiconductor devices. Beneficially, the member of the present disclosure overcomes the limitations associated with the conventional ultrawide bandgap technology, such as the disclosed member overcomes thermal limitations (e.g., low thermal conductivity) associated with a conventional gallium oxide layer by transfer of an active area of the gallium oxide layer into the gallium nitride buffer layer (or a suited gallium nitride), and on the silicon base substrate layer (or silicon carbide (SiC) substrates). Moreover, due to the improved thermal conductivity and higher electrical performance, the member can be utilized in power devices, or in optoelectronic devices.

According to the invention, the gallium oxide (Ga2O3) layer is deposited over the gallium nitride (GaN) buffer layer. In this implementation, the gallium oxide layer is in direct contact with the gallium nitride buffer layer. As a result, the member overcomes the thermal limitations associated with the conventional gallium oxide layer (or ultrawide bandgap technology).

In a further implementation form, the member further comprises a passivation layer between the gallium nitride (GaN) buffer layer and the gallium oxide (Ga2O3) layer, wherein the passivation layer comprises aluminium oxide, silicon dioxide or silicon nitride.

The passivation layer prevents oxidation of the gallium nitride (GaN) buffer layer.

In a further implementation form, the gallium oxide (Ga2O3) layer is deposited on the gallium nitride (GaN) buffer layer in an opening in the passivation layer.

In this implementation, selective placement of the gallium oxide layer is performed on a foreign substrate, such as on the gallium nitride (GaN) buffer layer and the silicon base substrate layer.

In a further implementation form, the gallium oxide (Ga2O3) layer is deposited over the gallium nitride (GaN) buffer layer, by being deposited on the passivation layer.

The passivation layer allows an improved adhesion with the gallium oxide layer and also reduces possible risks of delamination.

In a further implementation form, which does not form part of the claimed invention, the gallium oxide (Ga2O3) layer is deposited in an area defined by lithography etching removing at least a part of the passivation layer, wherein the gallium oxide (Ga2O3) layer is deposited on a remaining portion of the passivation layer.

In this implementation, selective placement of the gallium oxide layer is performed on the passivation layer.

In a further implementation form, which does not form part of the claimed invention, the gallium oxide (Ga2O3) layer is deposited on the silicon base substrate layer through an opening in the gallium nitride (GaN) buffer layer and the transition layer.

By virtue of using the opening, the gallium oxide layer comes in direct contact with the silicon base substrate layer. In a further implementation form, the member further comprises a passivation layer on the silicon base substrate layer. Beneficially, the passivation layer provides electrical isolation, and an improved adhesion between the silicon base substrate layer and the gallium oxide layer and also reduces risks of delamination.

In a further implementation form, the member further comprises a p-doped gallium nitride (GaN) layer arranged between the gallium nitride (GaN) buffer layer and the gallium oxide (Ga2O3) layer.

The p-doped gallium nitride layer (or p-type doping capability of gallium nitride technology) is beneficial to overcome the current limitation associated with doping in the conventional gallium oxide layer.

In a further implementation form, which does not form part of the claimed invention, the gallium oxide (Ga2O3) layer is n-doped.

By virtue of using the p-doped gallium nitride layer and the n-doped gallium oxide layer, a pn junction can be created between the p-doped gallium nitride layer and the n-doped gallium oxide layer.

According to the invention, the gallium oxide (Ga2O3) layer comprises an n-doped gallium oxide (Ga2O3) layer on top of a semi-insulating gallium oxide (Ga2O3) layer.

By virtue of using the n-doped gallium oxide layer and the semi-insulating gallium oxide layer, the member of the present disclosure overcomes the current limitation related to the material of the conventional gallium oxide layer in terms of doping capabilities.

According to the present invention, the MESFET device further comprises source node layer, gate node layer and drain node layer are arranged over the n-doped gallium oxide (Ga2O3) layer, and wherein one ohmic contact is formed between the n-doped gallium oxide (Ga2O3) layer and the source node layer and one ohmic contact is formed between the n-doped gallium oxide (Ga2O3) layer and the drain node layer.

The metal-semiconductor field-effect transistor (MESFET) device achieves all the advantages and technical effects of the member of the present disclosure.

In yet another aspect, which does not form part of the claimed invention, the present disclosure provides a metal-oxide-semiconductor field-effect transistor (MOSFET) device comprising a member, and wherein a source node layer, gate node layer and drain node layer are arranged over the n-doped gallium oxide (Ga2O3) layer, wherein one Ohmic contact is formed between the n-doped Ga2O3 layer and the source node layer and one ohmic contact is formed between the n-doped gallium oxide (Ga2O3) layer and the drain node layer, and wherein a dielectric layer is formed between the gate node layer and the source node layer, the n-doped gallium oxide (Ga2O3) layer, and the drain node layer.

The metal-oxide-semiconductor field-effect transistor (MOSFET) device achieves all the advantages and technical effects of the member of the present disclosure.

In a further implementation form, which does not form part of the claimed invention, the present disclosure provides the member, wherein the gallium oxide (Ga2O3) layer comprises an n- (Si) doped gallium oxide (Ga2O3) layer on top of a n+ (Sn) doped gallium oxide (Ga2O3) layer, and wherein an anode layer is formed over the n- (Si) doped gallium oxide (Ga2O3) layer and a cathode layer is formed under the gallium oxide (Ga2O3) layer, the member thereby forming a Schottky diode device.

The Schottky diode device achieves all the advantages and technical effects of the member of the present disclosure.

In yet another aspect, which does not form part of the claimed invention, the present disclosure provides the member, wherein the gallium oxide (Ga2O3) layer is arranged to partially cover the p-doped gallium nitride (GaN) layer, forming an exposed area of the p-doped gallium nitride (GaN) layer, and wherein the member further comprises a cathode formed on the gallium oxide (Ga2O3) layer and one or more anodes formed on the p-doped gallium nitride (GaN) layer.

The member is beneficial to form a blind ultra violet photodetector, which achieves all the advantages and technical effects of the member of the present disclosure.

In yet another aspect, which does not form part of the claimed invention, the present disclosure provides a power device comprising the member.

The power device achieves all the advantages and technical effects of the member of the present disclosure. Moreover, the disclosed power device provides high speed switching at reduced power consumption.

In yet another aspect, which does not form part of the claimed invention, the present disclosure provides an optoelectronic device comprising the member.

The optoelectronic device achieves all the advantages and technical effects of the member of the present disclosure. Moreover, the disclosed optoelectronic device provides an improved optical communication.

In yet another aspect, which does not form part of the claimed invention, the present disclosure provides a method for manufacturing a member, wherein the method comprises transferring the gallium oxide (Ga2O3) layer to the member.

The method achieves all the advantages and technical effects of the member of the present disclosure.

It is to be appreciated that all the aforementioned implementation forms can be combined, as long as the resulting implementation falls within the scope of the present invention, solely defined by the appended claims.

It has to be noted that all devices, elements, circuitry, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof. It will be appreciated that features of the present disclosure are susceptible to being combined in various combinations without departing from the scope of the present disclosure as defined by the appended claims.

Additional aspects, advantages, features and objects of the present disclosure would be made apparent from the drawings and the detailed description of the illustrative implementations construed in conjunction with the appended claims that follow.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale. Wherever possible, like elements have been indicated by identical numbers.

Embodiments of the present disclosure will now be described, by way of example only, with reference to the following diagrams wherein:
FIGs. 1A-1G are different schematic illustrations of a member which are not according to the invention and are provided as comparative examples only;
FIG. 2 is a flowchart of a method for manufacturing a member which is not according to the invention and is provided as a comparative example only;
FIG. 3 is a schematic illustration of a metal-semiconductor field-effect transistor device (MESFET) device, in accordance with the present invention;
FIGs. 4A-4C are different schematic illustrations of a metal-oxide-semiconductor field-effect transistor (MOSFET) device which are not according to the invention and are provided as comparative examples only;
FIGs. 5A-5B are different schematic illustrations of a Schottky diode device which are not according to the invention and are provided as comparative examples only;
FIG. 6 is a schematic illustration of a blind ultra violet (UV) photodetector which is not according to the invention and is provided as a comparative example only;
FIG. 7 is a block diagram of a power device which is not according to the invention and is provided as a comparative example only; and
FIG. 8 is a block diagram of an optoelectronic device which is not according to the invention and is provided as a comparative example only.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practicing the present disclosure are also possible.

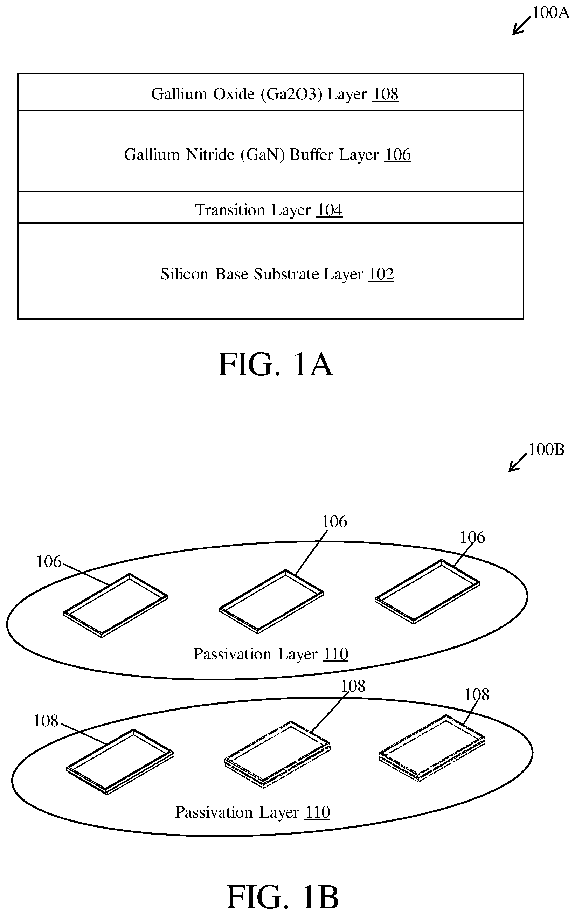

FIG. 1A is a schematic illustration of a member, in accordance with an embodiment of the present disclosure. With reference to FIG. 1A, there is shown a schematic illustration of a member **100A** that includes a silicon base substrate layer **102,** a transition layer **104,** a gallium nitride (GaN) buffer layer **106,** and a gallium oxide (Ga2O3) layer **108.** The present disclosure provides a member **100A** comprising:
a silicon base substrate layer **102;**
a transition layer **104** arranged over the silicon base substrate layer **102;** and
a gallium nitride (GaN) buffer layer **106** arranged over the transition layer **104,** wherein the member **100A** further comprises a gallium oxide (Ga2O3) layer **108.**

The member **100A** is a semiconductor structure that includes one or more layers of semiconductor material. In an example, the semiconductor material of one layer may be same (or different) as compared to the semiconductor material of another layer. The member **100A** may also comprise layers or structures of materials other than semiconductor materials. Further, the member **100A** may constitute a semiconductor device or be comprised in the semiconductor device. The member **100A** of the present disclosure implies co-integration of ultrawide-bandgap (UWBG) technology with wide bandgap technology, such as co-integration of the gallium oxide (Ga2O3) layer **108** to the gallium nitride buffer layer **106** on cheap silicon substrates, for example, on the silicon base substrate layer **102.**

The silicon base substrate layer **102** is a thin slice of semiconductor material, which may also be referred to as a single wafer or a chip. The silicon base substrate layer **102** acts as a base of the member **100A.** Due to its abundant availability, the silicon base substrate layer **102** is a low-cost material. The silicon base substrate layer **102** is available in different sizes, such as a size of six-inch (6"), eight-inch (8"), and twelve-inch (12").

The transition layer **104** is a layer of a material (e.g., compositionally-graded materials), which is used to provide sufficient strain relief, and to limit or prevent the formation of cracks in the gallium nitride buffer layer **106.**

The gallium nitride buffer layer **106** is a layer of gallium nitride semiconductor material, which is a wide-bandgap (WBG) semiconductor material. The bandgap of the gallium nitride buffer layer **106** is of a value of 3.4 electron volt (eV).

The gallium oxide (Ga2O3) layer **108** is a layer of gallium oxide semiconductor material, which is an ultra-wide bandgap (UWBG) semiconductor material. The bandgap of the gallium oxide layer **108** is of a value of 4.9 eV.

In other words, the silicon base substrate layer **102** of the member **100A** acts as a base of the member **100A.** Further, the transition layer **104** is deposited over the silicon base substrate layer **102.** The member **100A** further includes the gallium nitride buffer layer **106** arranged on the transition layer **104.** In other words, the gallium nitride buffer layer **106** is arranged on the silicon base substrate layer **102,** such as to form a GaN-On-Si substrate, as shown in FIG. 1A. Beneficially, the transition layer **104** provides sufficient strain relief and also limits or prevents the formation of cracks in the gallium nitride buffer layer **106.** Therefore, the member **100A** makes use of already existing gallium nitride (SiC or Si) technology infrastructure, such as the gallium nitride buffer layer **106** on a low cost silicon substrate, such as on the silicon base substrate layer **102.** Beneficially, the member **100A** makes use of consolidated gallium nitride (SiC or Si) process capabilities, such as by use of the gallium nitride buffer layer **106** in mass production of complementary metal-oxide-semiconductor (CMOS) line (e.g., of 6" and 8" and 12"). The member **100A** further includes the gallium oxide layer **108.** Therefore, the member **100A** makes use of the properties of the gallium oxide layer **108** (i.e., the ultrawide bandgap semiconductor material) to achieve higher electrical performance, for example, breakdown voltage (BV), figures-of-merit (FOMs), for power semiconductor devices. Beneficially, the member **100A** provides an improved thermal conductivity by transfer of an active area of the gallium oxide layer **108** into the gallium nitride buffer layer **106** (or a suited gallium nitride), and on the silicon base substrate layer **102** (or silicon carbide (SiC) substrates).

In accordance with an embodiment, the gallium oxide (Ga2O3) layer **108** is deposited over the gallium nitride (GaN) buffer layer **106.** In an example, the thickness of the gallium oxide layer **108** is from nanometer (nm) to micrometer (µm). Moreover, the gallium oxide layer **108** is in direct contact with the gallium nitride buffer layer **106.**

Therefore, the member **100A** uses different properties (e.g., ultrawide bandgap) of the gallium oxide layer **108** so as to achieve higher electrical performance (e.g., breakdown voltage (BV), figures-of-merit (FOMs)) for power semiconductor devices. Beneficially, the member **100A** overcome the limitations associated with the conventional ultrawide bandgap technology. For example, the member **100A** provides an improved thermal conductivity by transfer of an active area of the gallium oxide layer **108** into the gallium nitride buffer layer **106** (or a suited gallium nitride), and on the silicon base substrate layer **102** (or silicon carbide (SiC) substrates). Moreover, due to the improved thermal conductivity, the member **100A** is beneficial for utilization in a power device, or an optoelectronic device.

FIG. 1B is a schematic illustration of a member, in accordance with another embodiment of the present disclosure. FIG. 1B is described in conjunction with elements from FIG. 1A. With reference to FIG. 1B, there is shown a schematic illustration of a member **100B** that includes a passivation layer **110,** the gallium nitride (GaN) buffer layer **106,** and the gallium oxide (Ga2O3) layer **108.**

The passivation layer **110** is configured to prevent oxidation of the gallium nitride (GaN) buffer layer **106.** Examples of the passivation layer **110** include, but are not limited to, a silicon dioxide (SiO2) layer, a silicon nitride (SiN) layer, or an aluminum oxide (Al2O3) layer, and the like.

In accordance with an embodiment, the gallium oxide (Ga2O3) layer **108** is deposited on the gallium nitride (GaN) buffer layer **106** in an opening in the passivation layer **110.** In an example, the passivation layer **110** is initially deposited over the gallium nitride buffer layer **106.** Thereafter, the passivation layer **110** is removed at few points (or places) via lithography etching, photolithography, or e-beam lithography, so as to define the opening in the passivation layer **110.** Therefore, the gallium nitride buffer layer **106** is exposed through the opening, as shown in FIG. 1B. After that, the gallium oxide layer **108** is deposited in the opening and also over the gallium nitride buffer layer **106.** Therefore, selective placement of the gallium oxide layer **108** is performed on a foreign substrate, such as on the gallium nitride (GaN) buffer layer **106** and the silicon base substrate layer **102.**

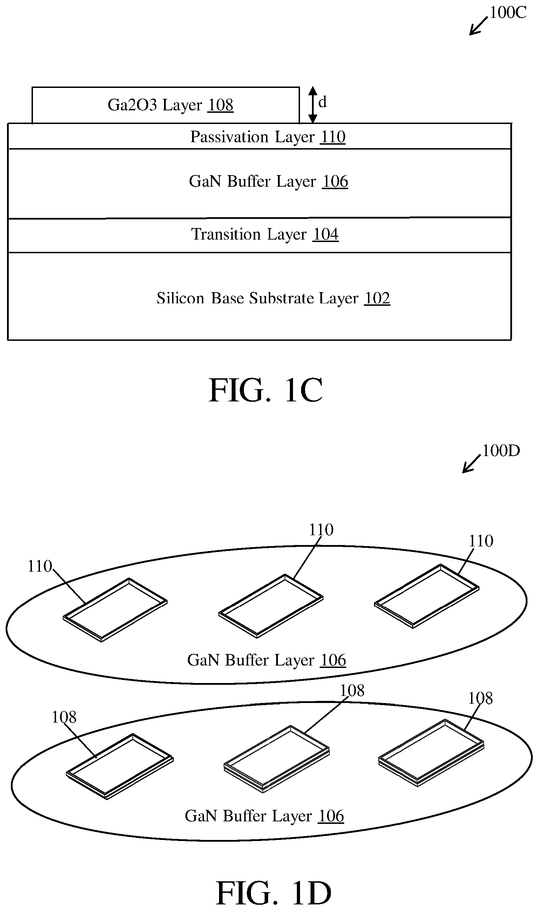

FIG. 1C is a schematic illustration of a member, in accordance with yet another embodiment of the present disclosure. FIG. 1C is described in conjunction with elements from FIGs. 1A, and 1B. With reference to FIG. 1C, there is shown a schematic illustration of a member **100C** that includes the silicon base substrate layer **102,** the transition layer **104,** the gallium nitride buffer layer **106,** the gallium oxide layer **108,** and the passivation layer **110.**

In accordance with an embodiment, the member **100C** comprises the passivation layer **110** between the gallium nitride (GaN) buffer layer **106** and the gallium oxide (Ga2O3) layer **108,** wherein the passivation layer **110** comprises, for example, aluminium oxide, silicon dioxide or silicon nitride. It is to be understood by one of ordinary skill in the art that other material similar in properties to that of aluminium oxide, silicon dioxide or silicon nitride, may be used without limiting the scope of the disclosure. In the member **100C,** the passivation layer **110** is deposited over the gallium nitride buffer layer **106.** Thereafter, the gallium oxide layer **108** is deposited over the passivation layer **110.** Beneficially, the passivation layer **110** prevents oxidation of the gallium nitride buffer layer **106.** Examples of the passivation layer **110** include, but are not limited to, the silicon dioxide (SiO2) layer, the silicon nitride (SiN) layer, or the aluminum oxide (Al2O3) layer, and the like. In an example, the passivation layer **110** is deposited via one of a well known possible passivation schemes, such as plasma-enhanced chemical vapor deposition (PECVD), low pressure chemical vapor deposition (LPCVP), atomic layer deposition (ALD) passivations, and the like.

In accordance with an embodiment, the gallium oxide (Ga2O3) layer **108** is deposited over the gallium nitride (GaN) buffer layer **106,** by being deposited on the passivation layer **110.** In the member **100C,** the passivation layer **110** is deposited on the gallium nitride buffer layer **106** and results in the formation of a passivated gallium nitride. Thereafter, the gallium oxide layer **108** is deposited over the passivation layer **110,** as shown in FIG. 1C. In the member **100C,** pieces (e.g., with a certain area and thickness) of the gallium oxide layer **108** are deposited on the passivated gallium nitride (or aluminium gallium nitride (AlGaN)) layer. Beneficially, the passivation layer **110** allows an improved adhesion with the gallium oxide layer **108** and also reduces possible risks of delamination.

FIG. 1D is a schematic illustration of a member, in accordance with another embodiment of the present disclosure. FIG. 1D is described in conjunction with elements from FIGs. 1A, 1B, and 1C. With reference to FIG. 1D, there is shown a schematic illustration of a member **100D** that includes the gallium nitride buffer layer **106,** the gallium oxide layer **108,** and the passivation layer **110.**

In accordance with an embodiment, the gallium oxide (Ga2O3) layer **108** is deposited in an area defined by lithography etching removing at least a part of the passivation layer **110,** wherein the gallium oxide (Ga2O3) layer **108** is deposited on a remaining portion of the passivation layer **110.** In other words, the passivation layer **110** is initially deposited over the gallium nitride buffer layer **106.** Thereafter, the lithography etching is used to define the area (or areas) where the passivation layer **110** is used as an underneath layer for deposition of the gallium oxide layer **108.** Alternatively stated, the lithography etching is used to remove at least a part of the passivation layer **110** from all over the gallium nitride buffer layer **106,** as shown in FIG.1D. After that, the gallium oxide layer **108** is deposited on the remaining portion of the passivation layer **110** (e.g., over-defined passivated areas). Beneficially, the member **100D** achieves a selective placement of the gallium oxide layer **108** on the passivation layer **110.**

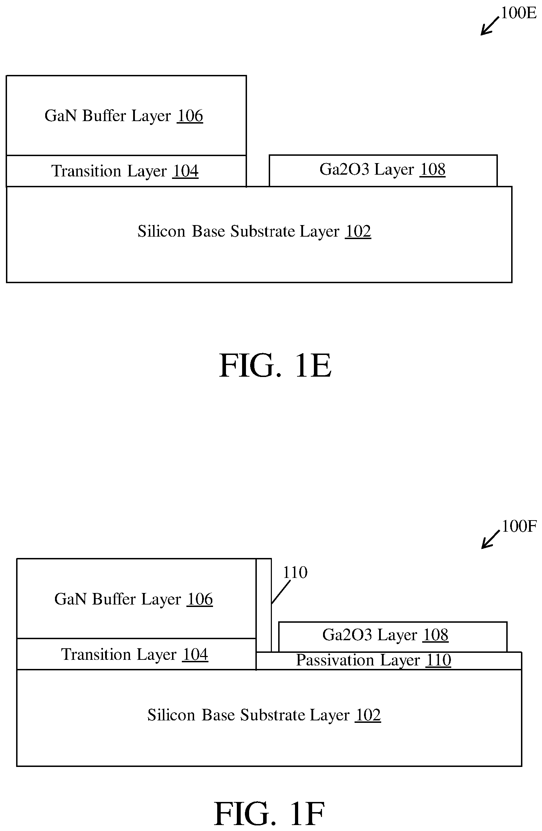

FIG. 1E is a schematic illustration of a member, in accordance with yet another embodiment of the present disclosure. FIG. 1E is described in conjunction with elements from FIGs. 1A, 1B, 1C, and 1D. With reference to FIG. 1E, there is shown a schematic illustration of a member **100E** that includes the silicon base substrate layer **102,** the transition layer **104,** the gallium nitride buffer layer **106,** and the gallium oxide layer **108.**

In accordance with an embodiment, the gallium oxide (Ga2O3) layer **108** is deposited on the silicon base substrate layer **102** through an opening in the gallium nitride (GaN) buffer layer **106** and the transition layer **104.** In other words, the transition layer **104** is deposited on the silicon base substrate layer **102,** and the gallium nitride buffer layer **106** is deposited on the transition layer **104.** Thereafter, the opening (or trench) is formed (e.g., via lithography) in the gallium nitride buffer layer **106** and also in the transition layer **104** so as to expose the silicon base substrate layer **102** underneath. Moreover, the gallium oxide layer **108** is deposited in the opening, as shown in FIG. 1E. In other words, the gallium oxide layer **108** is deposited on the silicon base substrate layer **102** (or an exposed silicon substrate). Therefore, the gallium oxide layer **108** is in direct contact with the silicon base substrate layer **102.** In an implementation, the silicon base substrate layer **102** is doped via p-type doping before the deposition of the gallium oxide layer **108.** In another implementation, the silicon base substrate layer **102** is doped via n-type doping before the deposition of the gallium oxide layer **108.**

FIG. 1F is a schematic illustration of a member, in accordance with another embodiment of the present disclosure. FIG. 1F is described in conjunction with elements from FIGs. 1A, 1B, 1C, 1D, and 1E. With reference to FIG. 1F, there is shown a schematic illustration of a member **100F** that includes the silicon base substrate layer **102,** the transition layer **104,** the gallium nitride buffer layer **106,** the gallium oxide layer **108,** and the passivation layer **110.**

In accordance with an embodiment, the member **100F** further comprises a passivation layer (i.e., the passivation layer **110)** on the silicon base substrate layer **102.** In an example, the transition layer **104** is deposited on the silicon base substrate layer **102,** and the gallium nitride buffer layer **106** is deposited on the transition layer **104.** Thereafter, an opening (or a trench) is formed (e.g., via lithography etching steps) in the gallium nitride buffer layer **106** and also in the transition layer **104** so as to expose the silicon base substrate layer **102** underneath. Thereafter, the passivation layer **110** is deposited in the opening on one side (e.g., vertical side) of the gallium nitride buffer layer **106,** and also on one side (e.g., horizontal side) of the transition layer **104,** as shown in FIG. 1F. Further, the gallium oxide layer **108** is deposited on the passivation layer **110.** Therefore, the passivation layer **110** is interposed between the silicon base substrate layer **102** (or exposed silicon substrate) and the gallium oxide layer **108.** Beneficially, the passivation layer **110** provides electrical isolation, and an improved adhesion between the silicon base substrate layer **102** and the gallium oxide layer **108** and also reduces risks of delamination. Additionally, the gallium oxide layer **108** can be deposited on the passivation layer **110** in a similar manner as obtained in the member **100B** (of FIG. 1B) and member **100D** (of FIG. 1D).

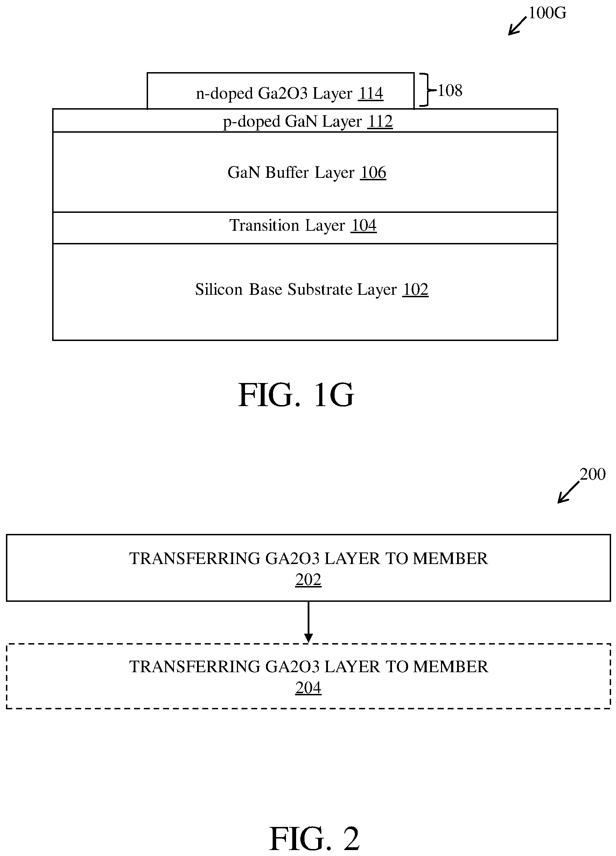

FIG. 1G is a schematic illustration of a member, in accordance with yet another embodiment of the present disclosure. FIG. 1G is described in conjunction with elements from FIGs. 1A, 1B, 1C, 1D, 1E, and 1F. With reference to FIG. 1G, there is shown a schematic illustration of a member **100G** that includes a p-doped gallium nitride (GaN) layer **112,** a n-doped gallium oxide (Ga2O3) layer **114,** the silicon base substrate layer **102,** the transition layer **104,** the gallium nitride buffer layer 106, and the gallium oxide layer **108.** The p-doped gallium nitride layer **112** corresponds to gallium nitride with p-type dopants, and the n-doped gallium oxide layer **114** corresponds to the gallium oxide layer **108** with n-type doping.

In accordance with an embodiment, the member **100G** comprises the p-doped gallium nitride (GaN) layer **112** arranged between the gallium nitride (GaN) buffer layer **106** and the gallium oxide (Ga2O3) layer **108.** In an example, the gallium nitride buffer layer **106** is deposited on the transition layer **104,** and the gallium nitride buffer layer **106** is further covered by the p-doped gallium nitride layer **112.** Thereafter, the gallium oxide layer **108** is deposited directly on the p-doped gallium nitride layer **112.** In an example, the gallium oxide layer **108** is deposited on a selective portion of the p-doped gallium nitride layer **112.** Beneficially, the member **100G** makes use of the p-doped gallium nitride layer **112** (or p-type doping capability of gallium nitride technology).

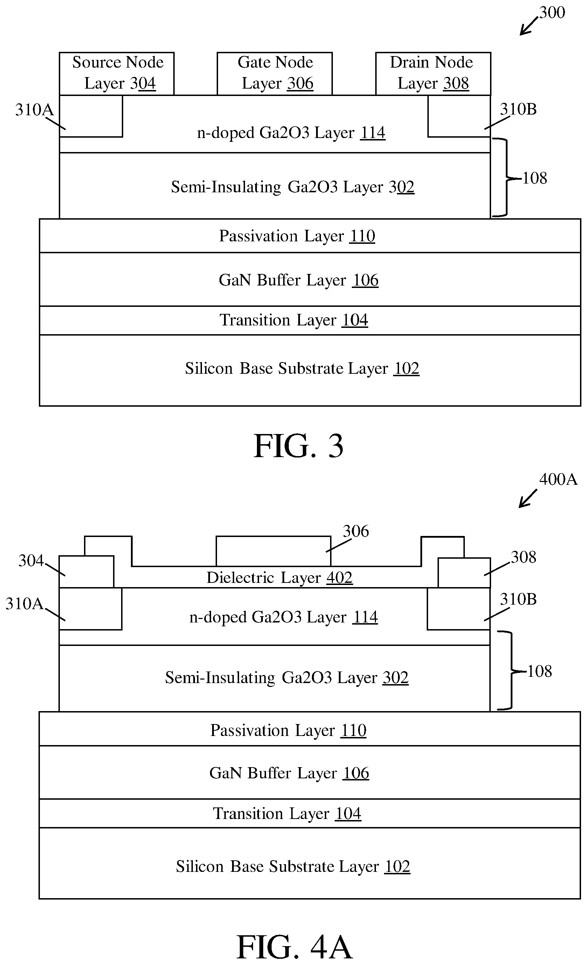

In accordance with an embodiment, the member **100G** is characterized in that the gallium oxide (Ga2O3) layer **108** is n-doped. As the gallium oxide layer **108** is n-doped, such as the n-doped gallium oxide layer **114** shown in FIG. 1G. Thus a PN junction is created between the n-doped gallium oxide layer **114** and the p-doped gallium nitride layer **112** (or gallium nitride material). By virtue of using the n-doped gallium oxide layer **114,** the member **100G** overcomes the limitation related to material of the conventional gallium oxide layer in terms of doping capabilities. In an implementation, the gallium oxide layer **108** comprises the n-doped gallium oxide layer **114,** which may be arranged over top of a semi-insulating gallium oxide layer, described in detail, for example, in FIG. 3.

FIG. 2 is a flowchart of a method for manufacturing a member, in accordance with an embodiment of the present disclosure. FIG. 2 is described in conjunction with elements from FIGs. 1A, 1B, 1C, 1D, 1E, 1F, and 1G. With reference to FIG. 2, there is shown a method **200** that includes steps **202** and **204.**

The method **200** for manufacturing a member (e.g., the member **100A),** wherein the method **200** comprises transferring the gallium oxide (Ga2O3) layer (i.e., the gallium oxide layer **108)** to the member (e.g., the member **100A).** The method **200** implies co-integration of ultrawide-bandgap (UWBG) technology with wide bandgap technology in order to improve thermal conductivity of the UWBG technology and to improve doping (p-type) capabilities of the UWBG technology. Alternatively stated, the method **200** provides co-integration of the gallium oxide (Ga2O3) layer **108** to the gallium nitride buffer layer **106** on cheap silicon substrates, for example, on the silicon base substrate layer **102** of the member **100A.** The method **200** is applicable to all of the members **100A, 100B, 100C, 100D, 100E, 100F,** and **100G.**

At step **202,** the method **200** comprises transferring the gallium oxide (Ga2O3) layer (i.e., the gallium oxide layer **108)** to the member (e.g., the member **100A).** For example, the member **100A** includes the silicon base substrate layer **102,** which acts as a base of the member **100A.** Thereafter, the transition layer **104** is deposited on the silicon base substrate layer **102,** and then the gallium nitride buffer layer **106** is deposited on the transition layer **104.** As a result, the member **100A** includes the silicon base substrate layer **102,** the transition layer **104,** and the gallium nitride buffer layer **106,** such as forming a GaN-On-Si substrate. Additionally, the method **200** comprises, transferring the gallium oxide (Ga2O3) layer **108** to the member **100A.** That means, the gallium oxide layer **108** is deposited on the gallium nitride buffer layer **106.** This way, the method **200** provides co-integration of the gallium oxide (Ga2O3) layer **108** to the gallium nitride buffer layer **106** on cheap silicon substrates. Therefore, the method **200** achieves higher electrical performance (BV, FOMs) for power semiconductor devices. Beneficially, the method **200** overcome the limitations associated with the conventional ultrawide bandgap technology. For example, the method **200** overcome thermal limitations associated with the conventional gallium oxide by transferring an active area of the gallium oxide layer **108** into the gallium nitride buffer layer **106** (or a suited gallium nitride), and on the silicon base substrate layer **102** (or silicon carbide (SiC) substrates), and thus, provides improved thermal conductivity.

At step **204,** the method **200** further comprises transferring the gallium oxide (Ga2O3) layer **108** to the member **100A.** In an example, the transferring the gallium oxide (Ga2O3) layer 108 to the member 100A may be done using a transfer technique, such as a smart cut technique or other known techniques of transfering fine layers of crystalline material onto a mechanical support. In other words, the method **200** comprises, transfer of the very fine layers of gallium oxide layer **108** to the member **100A** or deposition of the gallium oxie layer **108** on to the gallium nitride buffer layer 106 of the member **100A.** Generally, the smart cut technique is a technological process that enables transferring of very fine layers of crystalline silicon material onto a mechanical support. In an implementation, the application of the smart cut technique is mainly in the production of silicon-on-insulator (SOI) wafer substrates.

In accordance with an embodiment, the method 200 further comprises transferring the gallium oxide (Ga2O3) layer **108** to the member **100A** by utilizing a large area exfoliating technique. In other words, the method **200** comprises utilizing the large area exfoliating technique. In an example, the large area exfoliating technique permits cleaving or mechanical exfoliation of exfoliated layers (or thin flakes), such as the exfoliated layers of the gallium oxide layer **108.** The exfoliated layers of the gallium oxide layer **108** may then be transferred to any arbitrary substrates, such as on the member **100A.**

In accordance with an embodiment, the method **200** further comprises transferring the gallium oxide (Ga2O3) layer **108** to the member **100A** by utilizing an electrochemical etching technique. In other words, the method **200** comprises, utilizing the electrochemical or photo-electrochemical (PEC) etching technique that promotes a reaction by irradiated light having energy above bandgap and applied external bias. Therefore, the electrochemical etching technique can also be used as starting steps of the method **200** for transferring the gallium oxide layer **108** to the member **100A.** Beneficially, the electrochemical etching technique is very promising for high selectivity and also for the reduced number of new defects introduced.

Therefore, the method **200** comprises, using different properties (e.g., ultrawide bandgap) of the gallium oxide layer **108** so as to achieve higher electrical performance (e.g., breakdown voltage (BV), figures-of-merit (FOMs)) for power semiconductor devices. Beneficially, the method **200** overcome the limitations associated with the conventional ultrawide bandgap technology. For example, the method **200** overcome thermal limitations (e.g., low thermal conductivity) associated with the conventional gallium oxide by transfer of an active area of the gallium oxide layer **108** on the member **100A** (such as on the gallium nitride buffer layer **106** and on the silicon base substrate layer **102)** and provides an improved thermal conductivity.

The steps **202,** and **204** are only illustrative, and other alternatives can also be provided where one or more steps are added, one or more steps are removed, or one or more steps are provided in a different sequence without departing from the scope of the claims herein.

FIG. 3 is a schematic illustration of a metal-semiconductor field-effect transistor (MESFET) device, in accordance with an embodiment of the present invention. FIG. 3 is described in conjunction with elements from FIGs. 1A, 1B, 1C, 1D, 1E, 1F and 1G. With reference to FIG. 3, there is shown a schematic illustration of a metal-semiconductor field-effect transistor device **300** that includes a semi-insulating gallium oxide (Ga2O3) layer **302,** a source node layer **304,** a gate node layer **306,** a drain node layer **308,** and ohmic contacts **310A** and **310B.** The metal-semiconductor field-effect transistor (MESFET) device **300** further includes the member **100A,** which includes the silicon base substrate layer **102,** the transition layer **104,** the gallium nitride buffer layer 106, the passivation layer **110,** and the n-doped gallium oxide layer **114.**

The MESFET device **300** is a semiconductor device, which is generally used to amplify or switch electronic signals. The MESFET device **300** is one of the basic building blocks of modem electronics. The MESFET device **300** is composed of semiconductor material with at least three layers (or terminals), such as the source node layer **304,** the gate node layer **306,** and the drain node layer **308.**

The semi-insulating gallium oxide layer **302** may also be referred to as a semi-insulating substrate. In an example, the semi-insulating gallium oxide layer **302** is included by the gallium oxide layer **108** so as to stop subthreshold current. Examples of materials used for the semi-insulating gallium oxide layer **302** include but are not limited to magnesium (Mg), iron (Fe), carbon (C), and the like.

The source node layer **304,** the gate node layer **306,** and the drain node layer **308** corresponds to source, gate, and drain terminals of the MESFET device **300.** The source node layer **304,** the gate node layer **306,** and the drain node layer **308** are used for connection purposes (e.g., to connect the MESFET device **300** to a power supply). Examples of metals used to arrange the source node layer **304,** the gate node layer **306,** and the drain node layer **308** include, but are not limited to titanium/gold (Ti/Au). In an example, platinum (Pt) metal can be used to arrange the gate node layer **306** over the n-doped gallium oxide layer **114.**

The ohmic contacts **310A** and **310B** are used for current flow (and for further electrical connection). Examples of materials used for the formation of ohmic contacts **310A** and **310B** include, but not limited to titanium/gold (Ti/Au), titanium (Ti), indium (In), silver (Ag), tin (Sn), tungsten (W), molybdenum (Mo), scandium (Sc), zinc (Zn), and zirconium (Zr).

In accordance with the invention, the gallium oxide (Ga2O3) layer **108** comprises an n-doped gallium oxide (Ga2O3) layer **114** on top of a semi-insulating gallium oxide (Ga2O3) layer **302.** The MESFET device **300** is based on the member **100A** that includes the transition layer **104,** such as the transition layer **104** is deposited on the silicon base substrate layer **102,** and the gallium nitride buffer layer **106** that is deposited on the transition layer **104.** Moreover, the gallium oxide layer **108** is deposited on the gallium nitride buffer layer **106,** and the gallium oxide layer **108** further includes the semi-insulating gallium oxide layer **302** and the n-doped gallium oxide layer **114.** The semi-insulating gallium oxide layer **302** is deposited on the gallium nitride buffer layer **106,** and the n-doped gallium oxide layer **114** is deposited on the semi-insulating gallium oxide layer **302,** as shown in FIG. 3. Optionally, the member **100A** of the MESFET device **300** can include the passivation layer **110** deposited on the gallium nitride buffer layer **106,** and in that case, the semi-insulating gallium oxide layer **302** can be deposited on the passivation layer **110.**

Beneficially, the semi-insulating gallium oxide layer **302** (or a semi-insulating substrate) is included by the gallium oxide layer **108** to stop the subthreshold current. However, the MESFET device **300** can be manufactured depending on one of the members **100B, 100C,** and **100D.**

The metal-semiconductor field-effect transistor (MESFET) device **300** comprising a member **100A,** wherein the member **100A** further comprises a source node layer **304,** gate node layer **306** and drain node layer **308** are arranged over the n-doped gallium oxide (Ga2O3) layer **114,** and wherein one ohmic contact **310A** is formed between the n-doped gallium oxide (Ga2O3) layer **114** and the source node layer **304** and one ohmic contact **310B** is formed between the n-doped gallium oxide (Ga2O3) layer **114** and the drain node layer **308.** In other words, the MESFET device **300** includes the member **100A,** which further includes the formation of two ohmic contacts on (e.g., both sides of) the n-doped gallium oxide layer **114,** which are used for current flow. Thereafter, the source node layer **304,** the gate node layer **306,** and the drain node layer **308** are arranged directly over the n-doped gallium oxide layer **114.** As a result, the ohmic contact **310A** is arranged between the n-doped gallium oxide layer **114** and the source node layer **304,** and the ohmic contact **310B** is arranged between the n-doped gallium oxide layer **114** and the drain node layer **308.** Therefore, the MESFET device **300** is beneficial to co-integrate the n-doped gallium oxide layer **114** and the semi-insulating gallium oxide layer **302** (or the ultrawide bandgap technology) with the gallium nitride buffer layer **106** and the silicon base substrate layer **102** (or GaN-on-Si technology). Moreover, the MESFET device **300** is beneficial for high-power electronics. As the MESFET device **300** is a unipolar device because its conduction process (i.e., current flow) involves predominantly only one kind of charge carrier (i.e., either electrons or holes). Thus, the MESFET device **300** has higher switching speeds and higher operating frequencies than bipolar transistors.

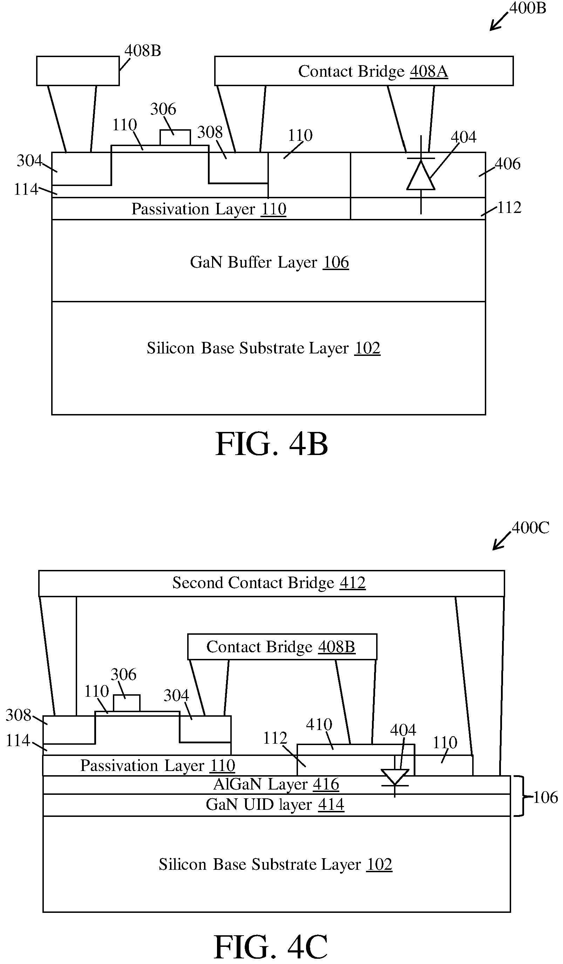

In accordance with an embodiment, a metal-semiconductor field-effect transistor (MESFET) device **300** comprising a diode, wherein the member **100A** further comprises a second gallium oxide (Ga2O3) layer arranged with the p-doped gallium nitride (GaN) layer **112** being arranged under the second Ga2O3 layer, wherein the second gallium oxide (Ga2O3) layer is connected to the drain node layer **308** through a contact bridge. In an implementation, the MESFET device **300** may include the diode and for which the member **100A** includes the p-doped gallium nitride layer **112** arranged on the gallium nitride buffer layer **106.** The member **100A** further includes the second gallium oxide layer (shown in FIG. 4B), which is arranged on the p-doped gallium nitride layer **112.** The connection of the second gallium oxide layer with the p-doped gallium nitride layer **112** leads to the formation of the diode in the MESFET device **300.** In addition, the contact bridge is used by the member **100A** to connect the second gallium oxide layer to the drain node layer **308** of the member **100A.** Therefore, the member **100A** is beneficially used to fabricate a power transistor (i.e., the MESFET device **300)** with an integrated body diode. In an implementation, the second gallium oxide layer is connected to the drain node layer **308** (i.e., the two contacts are connected) through via's, which can be formed on the drain node layer **308** (or an upper metalization level) in order to form a common contact.

In accordance with an embodiment, a metal-semiconductor field-effect transistor (MESFET) device **300** comprising a diode, wherein the member **100A** further comprises a p-doped gallium nitride (GaN) layer **112** being arranged over the gallium nitride (GaN) buffer layer **106,** wherein the p-doped gallium nitride (GaN) layer **112** is connected via an ohmic contact to the source node layer **304** through a contact bridge and wherein the gallium nitride buffer layer **106** is connected via an ohmic contact to the drain node layer **308** through a second contact bridge. In other words, the MESFET device **300** includes the diode and the member **100A.** The member **100A** further includes the p-doped gallium nitride layer **112** arranged on the gallium nitride buffer layer **106.** In an example, the ohmic contact (not shown in FIG. 3, however, shown in FIG. 4C) is formed on the p-doped gallium nitride layer **112,** and another ohmic contact (not shown in FIG. 3) is formed on the gallium nitride buffer layer **106.** The ohmic contact formed on the p-doped gallium nitride layer **112** further connects the p-doped gallium nitride (GaN) layer **112** with the source node layer **304** of the member **100A** through the contact bridge (not shown in FIG. 3). Alternatively, the contact bridge and the ohmic contact connect the p-doped gallium nitride (GaN) layer **112** with the source node layer **304** of the member **100A.** In addition, the ohmic contact formed (not shown in FIG. 3) on the gallium nitride buffer layer **106** further connects the gallium nitride buffer layer **106** with the drain node layer **308** of the member **100A** through the second contact bridge (not shown in FIG. 3). Alternatively, the second contact bridge and the ohmic contact connect the gallium nitride buffer layer **106** with the drain node layer **308** of the member **100A.** Therefore, the member **100A** is beneficial to fabricate a power transistor with an integrated body diode, such as to fabricate MESFET device **300** with the diode arranged between the gallium nitride buffer layer **106** and the ohmic contact.

In accordance with an embodiment, the member **100A** is further characterized in that the gallium nitride (GaN) buffer layer **106** comprises an aluminium gallium nitride (AlGaN) layer on top of a gallium nitride (GaN) un-intentionally doped (UID) layer. In the MESFET device **300,** the gallium nitride buffer layer **106** of the member **100A** includes the aluminium gallium nitride (AlGaN) layer on top of the gallium nitride (GaN) un-intentionally doped (UID) layer. Alternatively stated, the gallium nitride un-intentionally doped layer (of the gallium nitride buffer layer **106)** is directly deposited on the silicon base substrate layer **102,** and the aluminium gallium nitride layer (of the gallium nitride buffer layer **106)** is deposited on the gallium nitride un-intentionally doped layer. Beneficially, the aluminium gallium nitride layer of the gallium nitride buffer layer **106** provides an improved electrical connection with the drain node layer **308** of the MESFET device 300. In an implementation, a two dimensional electron gas is formed at an interface between the aluminium gallium nitride layer (AlGaN) layer and the gallium nitride un-intentionally doped layer undernearth. Moreover, the diode of the MESFET device **300** is formed between the p-doped gallium nitride layer **112** and the two dimensional electron gas.

In accordance with an embodiment, at least one of the ohmic contacts comprises titanium and/or gold. As the ohmic contacts are used for current flow and for further electrical connection purposes, thus by virtue of using the titanium and/or gold metals, an improved electrical connection is obtained through the ohmic contacts (e.g., the ohmic contacts **310A** and **310B)** of the member **100A.**

FIG. 4A is a schematic illustration of a metal-oxide-semiconductor field-effect transistor (MOSFET) device, in accordance with an embodiment of the present disclosure. FIG. 4A is described in conjunction with elements from FIGs. 1A, 1B, 1C, 1D, 1E, 1F, 1G, and 3. With reference to FIG. 4A, there is shown a schematic illustration of a metal-oxide-semiconductor field-effect transistor (MOSFET) device **400A** that includes a dielectric layer **402,** the silicon base substrate layer **102,** the transition layer **104,** the gallium nitride buffer layer **106,** the passivation layer **110,** the n-doped gallium oxide layer **114,** the semi-insulating gallium oxide (Ga2O3) layer **302,** the source node layer **304,** the gate node layer **306,** the drain node layer **308,** and the ohmic contacts **310A** and **310B.**

The MOSFET device **400A** is a semiconductor device, which is generally used to amplify or switch electronic signals. The MOSFET device **400A** is one of the basic building blocks of modem electronics. The MOSFET device **400A** is composed of semiconductor material with different layers (or terminals), such as the source node layer **304,** the gate node layer **306,** the drain node layer **308,** and the dielectric layer **402.**

The dielectric layer **402** may also be referred to as gate dielectrics. Examples of materials used for the formation of the dielectric layer **402** include, but are not limited to, aluminium oxide (Al2O3), silicon nitride (SiN), silicon oxide (or dioxide) (SiO2), hafnium oxide (HfO2), and zirconium dioxide (ZrO2). Beneficially, the dielectric layer **402** is used to protect (or prevent oxidation of) the n-doped gallium oxide layer **114.**

The present disclosure provides a metal-oxide-semiconductor field-effect transistor (MOSFET) device **400A** comprising a member **100A,** wherein a source node layer **304,** gate node layer **306** and drain node layer **308** are arranged over the n-doped gallium oxide (Ga2O3) layer **114,** wherein one ohmic contact **310A** is formed between the n-doped gallium oxide (Ga2O3) layer **114** and the source node layer **304** and one ohmic contact **310B** is formed between the n-doped gallium oxide (Ga2O3) layer **114** and the drain node layer **308,** and wherein a dielectric layer **402** is formed between the gate node layer **306** and the source node layer **304,** the n-doped gallium oxide (Ga2O3) layer **114,** and the drain node layer **308.** In other words, the MOSFET device **400A** includes the member **100A** that further includes the silicon base substrate layer **102,** and the transition layer **104** that is deposited on the silicon base substrate layer **102,** and the gallium nitride buffer layer **106,** which is deposited on the transition layer **104.** The member **100A** of the MOSFET device **400A** further includes the passivation layer **110,** and the gallium oxide layer **108,** such as the passivation layer **110** is deposited on the gallium nitride buffer layer **106,** and the gallium oxide layer **108** is arranged on the passivation layer **110.** In an example, the gallium oxide layer **108** further includes the semi-insulating gallium oxide layer **302** and the n-doped gallium oxide layer **114,** as shown in FIG. 4A. Alternatively, the semi-insulating gallium oxide layer **302** is deposited on the gallium nitride buffer layer **106,** and the n-doped gallium oxide layer **114** is deposited on the semi-insulating gallium oxide layer **302.** The member **100A** of the MOSFET device **400A** further includes the formation of two ohmic contacts **310A** and **310B** on the n-doped gallium oxide layer **114,** which are used for current flow. Thereafter, the source node layer **304** and the drain node layer **308** are arranged directly over the n-doped gallium oxide layer **114.** As a result, one ohmic contact **310A** is arranged between the n-doped gallium oxide layer **114** and the source node layer **304,** and one ohmic contact **310B** is arranged between the n-doped gallium oxide layer **114** and the drain node layer **308.** Thereafter, the dielectric layer **402** is formed on the n-doped gallium oxide layer **114.** In an example, the dielectric layer **402** is formed to partially cover the drain node layer **308** and the source node layer **304.** The member **100A** of the MOSFET device **400A** further includes the gate node layer **306,** which is arranged directly on the dielectric layer **402.** For example, the gate node layer **306** is arranged on a selective area of the dielectric layer **402** (or gate dielectrics). As a result, the dielectric layer **402** of the MOSFET device **400A** is formed between the gate node layer **306.** the source node layer **304,** the n-doped gallium oxide layer **114,** and the drain node layer **308.** Examples of materials used for the formation of the dielectric layer **402** include, but are not limited to, aluminium oxide (Al2O3), silicon nitride (SiN), silicon oxide (or dioxide) (SiO2), hafnium oxide (HfO2), and zirconium dioxide (ZrO2). Beneficially, the dielectric layer **402** is used to protect or prevent oxidation of the n-doped gallium oxide layer **114.** Therefore, the MOSFET device **400A** is beneficial to co-integrate the n-doped gallium oxide layer **114** and the semi-insulating gallium oxide layer **302** (or the ultrawide bandgap technology) with the gallium nitride buffer layer **106** and the silicon base substrate layer **102** (or GaN-on-Si technology). The MOSFET device **400A** is beneficial for use in high-power electronics due to the improved thermal conductivity and higher electrical performance of the member **100A.**

FIG. 4B is a schematic illustration of a metal-oxide-semiconductor field-effect transistor device, in accordance with another embodiment of the present disclosure. FIG. 4B is described in conjunction with elements from FIGs. 1A, 1B, 1C, 1D, 1E, 1F, 1G, 3, and 4A. With reference to FIG. 4B, there is shown a schematic illustration of a metal-oxide-semiconductor field-effect transistor device **400B** that includes a diode **404** a second gallium oxide (Ga2O3) layer **406,** a contact bridge **408A,** and another contact bridge **408B.** The metal-oxide-semiconductor field-effect transistor device **400B** further includes the silicon base substrate layer **102,** the gallium nitride buffer layer **106,** the passivation layer **110,** the p-doped gallium nitride layer **112,** the n-doped gallium oxide layer **114,** the source node layer **304,** the gate node layer **306,** and the drain node layer **308.**

The diode **404** is a two-terminal semiconductor device that acts as a one-way switch for current flow, and may also be referred to as a body diode, integrated body diode, and the like. In general, the diode **404** allows current to flow easily in one direction but restricts the current flow in an opposite direction. The second gallium oxide layer **406** is similar to the gallium oxide layer **108.**

Each of the contact bridge **408A** and the other contact bridge **408B** is used as an electrode contact terminal. The contact bridge **408A** and the other contact bridge **408B** corresponds to an aerial circuit line, such as for current transfer.

In accordance with an embodiment, a metal-oxide-semiconductor field-effect transistor (MOSFET) device **400B** comprising a diode **404,** wherein the member **100A** further comprises a second gallium oxide (Ga2O3) layer **406** arranged with the p-doped gallium nitride (GaN) layer **112** being arranged under the second gallium oxide (Ga2O3) layer **406,** wherein the second gallium oxide (Ga2O3) layer **406** is connected to the drain node layer **308** through a contact bridge **408A.** In other words, the MOSFET device **400B** includes the diode **404** and the member **100A.** The member **100A** further includes the gallium nitride buffer layer **106,** which is deposited directly on the silicon base substrate layer **102.** The member **100A** further includes the passivation layer **110,** which is deposited selectively on the gallium nitride buffer layer **106,** and the n-doped gallium oxide layer **114** is also arranged selectively on the passivation layer **110.** The member **100A** further includes the p-doped gallium nitride layer **112** arranged selectively on a portion of the gallium nitride buffer layer **106,** and the second gallium oxide layer **406** arranged on the p-doped gallium nitride layer **112.** The connection of the second gallium oxide layer **406** over the p-doped gallium nitride layer **112** leads to the formation of the diode **404** in the MOSFET device **400B.** In addition, the contact bridge **408A** is used by the member **100A** to connect the second gallium oxide layer **406** to the drain node layer **308** of the member **100A.** In an example, the member **100A** further uses the other contact bridge **408B** to connect the source node layer **304** with the p-doped gallium nitride layer **112,** as further shown and described in FIG. 4C. Therefore, the MOSFET device **400B** acts as a power transistor with an integrated body diode, such as with the diode 404. Moreover, the MOSFET device **400B** is beneficial for power electronics, and other such applications.

FIG. 4C is a schematic illustration of a metal-oxide-semiconductor field-effect transistor device, in accordance with yet another embodiment of the present disclosure. FIG. 4C is described in conjunction with elements from FIGs. 1A, 1B, 1C, 1D, 1E, 1F, 1G, 3, 4A, and 4B. With reference to FIG. 4C, there is shown a schematic illustration of a metal-oxide-semiconductor field-effect transistor device **400C** that includes an ohmic contact **410,** a second contact bridge **412,** a gallium nitride (GaN) un-intentionally doped (UID) layer **414,** and an aluminium gallium nitride (AlGaN) layer **416.** The metal-oxide-semiconductor field-effect transistor device **400C** further includes the silicon base substrate layer **102,** the gallium nitride buffer layer **106,** the passivation layer **110,** the p-doped gallium nitride layer **112,** the n-doped gallium oxide layer **114,** the source node layer **304,** the gate node layer **306,** the drain node layer **308,** the diode **404,** and the other contact bridge **408B.**

In accordance with an embodiment, a metal-oxide-semiconductor field-effect transistor (MOSFET) device **400C** comprising a diode **404,** wherein the member **100A** further comprises a p-doped gallium nitride (GaN) layer **112** being arranged over the gallium nitride (GaN) buffer layer **106,** wherein the p-doped gallium nitride (GaN) layer **112** is connected via an ohmic contact **410** to the source node layer **304** through a contact bridge (i.e., the other contact bridge **408B)** and wherein the gallium nitride (GaN) buffer layer **106** is connected via an ohmic contact to the drain node layer **308** through a second contact bridge **412.** In other words, the metal-oxide-semiconductor field-effect transistor (MOSFET) device **400C** includes the diode **404** and the member **100A.** The member **100A** includes the gallium nitride buffer layer **106,** which is deposited directly on the silicon base substrate layer **102,** and the passivation layer **110,** which is deposited selectively on the gallium nitride buffer layer **106.** The member **100A** further includes the p-doped gallium nitride layer **112** arranged on the gallium nitride buffer layer **106.** The member **100A** further includes the ohmic contact **410,** which is formed (e.g., using deposition) on the p-doped gallium nitride layer **112.** The ohmic contact **410** connects the p-doped gallium nitride (GaN) layer **112** with the source node layer **304** through the other contact bridge **408B.** Alternatively, the other contact bridge **408B** and the ohmic contact **410** connect the p-doped gallium nitride (GaN) layer **112** with the source node layer **304** of the MOSFET device **400C.** In an example, an ohmic contact (not shown in FIG. 4C) is also formed on the gallium nitride buffer layer **106,** which connects the gallium nitride buffer layer **106** with the second contact bridge **412.** The second contact bridge **412** is further connected with the drain node layer **308** of the member **100A.** Therefore, the member **100A** of the present disclosure is beneficial to fabricate a power transistor with an integrated body diode, such as to fabricate the MOSFET device **400C** with the diode **404** arranged between the gallium nitride buffer layer **106** and the ohmic contact **410.**

In accordance with an embodiment, the member **100A** is further characterized in that the gallium nitride (GaN) buffer layer **106** comprises a aluminium gallium nitride (AlGaN) layer **416** on top of a gallium nitride (GaN) un-intentionally doped (UID) layer **414.** Alternatively stated, the gallium nitride un-intentionally doped layer **414** (of the gallium nitride buffer layer **106)** is directly deposited on the silicon base substrate layer **102,** and the aluminium gallium nitride layer **416** (of the gallium nitride buffer layer **106)** is deposited on the gallium nitride un-intentionally doped layer **414.** Beneficially, the aluminium gallium nitride layer **416** of the gallium nitride buffer layer **106** provides an improved connection with the drain node layer **308** of the member **100A** through the second contact bridge **412.**

In accordance with an embodiment, at least one of the ohmic contacts comprises titanium and/or gold. As the ohmic contacts are used for connection purposes, thus by virtue of using the titanium and/or gold metals, an improved connection is obtained through one of the ohmic contacts of the member **100A.**

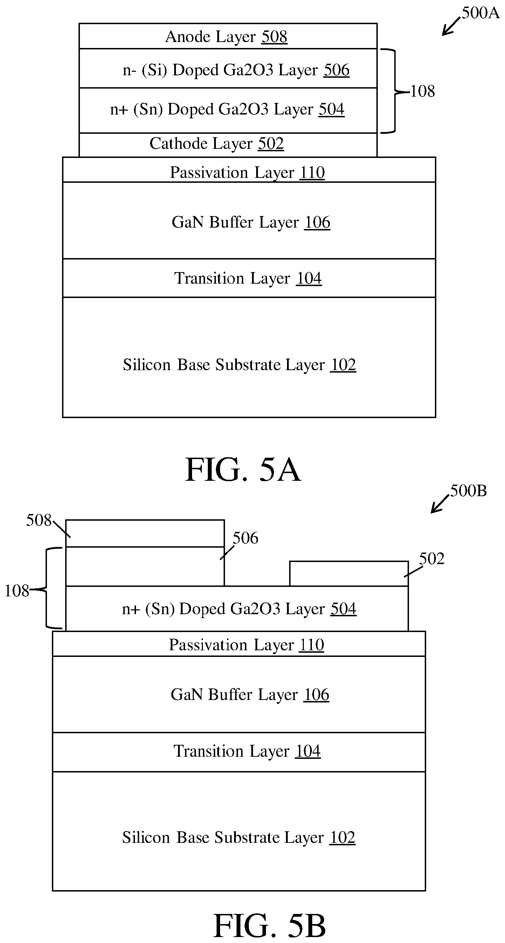

FIG. 5A is a schematic illustration of a Schottky diode device, in accordance with an embodiment of the present disclosure. FIG. 5A is described in conjunction with elements from FIGs. 1A, 1B, 1C, 1D, 1E, 1F, and 1G. With reference to FIG. 5A, there is shown a schematic illustration of a Schottky diode device **500A** that includes a cathode layer **502,** a n+ (Sn) doped gallium oxide (Ga2O3) layer **504,** a n- (Si) doped gallium oxide (Ga2O3) layer **506,** and an anode layer **508.** The Schottky diode device **500A** further includes the silicon base substrate layer **102,** the transition layer **104,** the gallium nitride buffer layer **106,** the gallium oxide layer 108, and the passivation layer **110.**

The Schottky diode device **500A** is a semiconductor diode (or a metal-semiconductor junction diode), which may also be referred to as a hot-carrier diode or Schottky barrier diode. The Schottky diode device **500A** has very fast switching action, for different applications (e.g., power electronics).

The cathode layer **502** and the anode layer **508** corresponds to two terminals of the Schottky diode device **500A.** In an example, the anode layer **508** is a metal side of the Schottky diode device **500A,** and the cathode layer **502** is the semiconductor side of the Schottky diode device **500A.** In an implementation, the anode layer **508** comprises platinum, titanium or gold, and the cathode layer **502** comprises titanium or gold metal.

The n+ (Sn) doped gallium oxide (Ga2O3) layer **504** corresponds to a gallium oxide, which is doped with n+ tin (Sn), and the n- (Si) doped gallium oxide (Ga2O3) layer **506** corresponds to a gallium oxide, which is doped with n- silicon (Si).

The present disclosure provides the member **100A,** wherein the gallium oxide (Ga2O3) layer **108** comprises an n- (Si) doped gallium oxide (Ga2O3) layer **506** on top of a n+ (Sn) doped gallium oxide (Ga2O3) layer **504,** and wherein an anode layer **508** is formed over the n- (Si) doped gallium oxide (Ga2O3) layer **506** and a cathode layer **502** is formed under the gallium oxide (Ga2O3) layer **108,** the member **100A** thereby forming a Schottky diode device **500A.** In other words, the member **100A** is included by the Schottky diode device **500A,** and the member **100A** includes the transition layer **104** deposited on the silicon base substrate layer **102** and the gallium nitride buffer layer **106** deposited directly on the transition layer **104.** The member **100A** further includes the cathode layer **502,** which is formed on the gallium nitride buffer layer **106.** Optionally, the passivation layer **110** can also be formed on the gallium nitride buffer layer **106,** and in that case, the cathode layer **502** will be formed on the passivation layer 110, as shown in FIG. 5A. The member **100A** further includes the gallium oxide layer **108** arranged on the cathode layer **502.** The gallium oxide layer **108** further includes the n+ (Sn) doped gallium oxide layer **504** and the n- (Si) doped gallium oxide layer **506.** Such as the n+ (Sn) doped gallium oxide layer **504** is deposited on the cathode layer **502,** and the n- (Si) doped gallium oxide layer **506** is deposited on the n+ (Sn) doped gallium oxide layer **504.** Thereafter, the member **100A** includes the anode layer **508,** which is formed on the n- (Si) doped gallium oxide layer **506.** As a result, the member **100A** forms the Schottky diode device **500A,** which is beneficial for high-power electronics. In an example, the Schottky diode device **500A** includes a metal stack for Schottky contacts. Examples of the metals used in the metal stack for Schottky contacts include, but not limited to, nickel (Ni), platinum (Pt), palladium (Pd), tungsten (W), copper (Cu), iridium (Ir). Moreover, by virtue of using the member **100A,** the Schottky diode device **500A** is beneficial to co-integrate the n-(Si) doped gallium oxide layer **506** and the n+ (Sn) doped gallium oxide layer **504** with the gallium nitride buffer layer **106** and the silicon base substrate layer **102** (or GaN-on-Si technology).

FIG. 5B is a schematic illustration of a Schottky diode device, in accordance with another embodiment of the present disclosure. FIG. 5B is described in conjunction with elements from FIGs. 1A, 1B, 1C, 1D, 1E, 1F, 1G, and 5A. With reference to FIG. 5B, there is shown a schematic illustration of a Schottky diode device **500B** that includes the silicon base substrate layer **102,** the transition layer **104,** the gallium nitride buffer layer **106,** the gallium oxide layer **108,** and the passivation layer **110.** The Schottky diode device **500B** further includes the cathode layer **502,** the n+ (Sn) doped gallium oxide (Ga2O3) layer **504,** the n- (Si) doped gallium oxide (Ga2O3) layer **506,** and the anode layer **508.**

In accordance with an embodiment, the gallium oxide (Ga2O3) layer **108** comprises an n- (Si) doped gallium oxide (Ga2O3) layer **506** on top of a n+ (Sn) doped gallium oxide (Ga2O3) layer **504,** wherein the n- (Si) doped gallium oxide (Ga2O3) layer **506** partially covering the n+ (Sn) doped gallium oxide (Ga2O3) layer **504,** forming an exposed area of the n+ (Sn) doped gallium oxide (Ga2O3) layer **504** and wherein an anode layer **508** is formed over the n-(Si) doped gallium oxide (Ga2O3) layer **506** and a cathode layer **502** is formed over the exposed area of the n+ (Sn) doped gallium oxide (Ga2O3) layer **504,** the member **100A** thereby forming a Schottky diode device **500B.** In other words, the Schottky diode device **500B** includes the member **100A,** such as the member **100A** further includes the transition layer **104** deposited on the silicon base substrate layer **102,** and the gallium nitride buffer layer **106** deposited directly on the transition layer **104.** The member **100A** further includes gallium oxide layer **108,** which is formed on the gallium nitride buffer layer **106.** The gallium oxide layer **108** further includes the n- (Si) doped gallium oxide layer **506,** and the n+ (Sn) doped gallium oxide layer **504,** such as the n+ (Sn) doped gallium oxide layer **504** is deposited on the gallium nitride buffer layer **106,** and the n- (Si) doped gallium oxide layer **506** is deposited on the n+ (Sn) doped gallium oxide layer **504.** Optionally, the passivation layer **110** can be formed on the gallium nitride buffer layer **106,** and in that case, the n+ (Sn) doped gallium oxide layer **504** is formed on the passivation layer **110,** and the n- (Si) doped gallium oxide layer **506** is deposited on the n+ (Sn) doped gallium oxide layer **504** as shown in FIG. 5B. In such a case, the n- (Si) doped gallium oxide layer **506** is arranged to partially cover the n+ (Sn) doped gallium oxide layer **504,** which results in the formation of the exposed area of the n+ (Sn) doped gallium oxide layer **504.** Alternatively, the n+ (Sn) doped gallium oxide layer **504** is partially covered by the n- (Si) doped gallium oxide layer **506** and partially exposed so that the cathode layer **502** is formed on the exposed area of the n+ (Sn) doped gallium oxide (Ga2O3) layer **504.** At last, the member **100A** includes the anode layer **508,** which is formed on the n- (Si) doped gallium oxide layer **506** so as to reduce the overall size of the Schottky diode device **500B.** Therefore, the member **100A** forms the Schottky diode device **500B,** which is beneficial for high-power electronics. By virtue of using the member **100A,** the Schottky diode device **500B** is beneficial to co-integrate the n- (Si) doped gallium oxide layer **506,** and the n+ (Sn) doped gallium oxide layer **504** with the gallium nitride buffer layer **106** and the silicon base substrate layer **102** (or GaN-on-Si technology).

In accordance with an embodiment, the anode layer **508** comprises platinum (Pt), titanium (Ti) or gold (Au) and the cathode layer **502** comprises titanium (Ti) or gold (Au). As the anode layer **508** and the cathode layer **502** are further used for connection purposes, such as to connect the Schottky diode device **500B** to a power supply. Thus by use of the platinum, titanium or gold for the anode layer **508** and the titanium or gold metal for the cathode layer **502,** an improved connection can be obtained through the anode layer **508** and the cathode layer **502.**

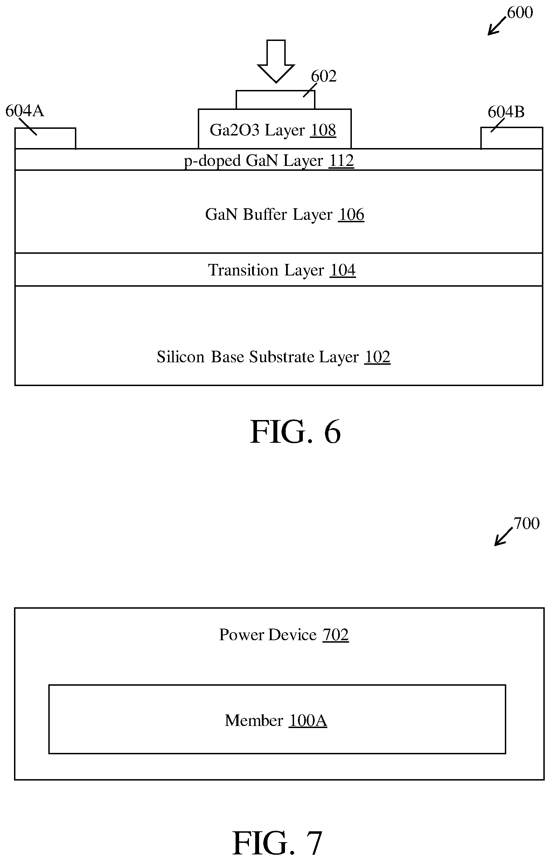

FIG. 6 is a schematic illustration of a blind ultra violet (UV) photodetector, in accordance with an embodiment of the present disclosure. FIG. 6 is described in conjunction with elements from FIGs. 1A, 1B, 1C, 1D, 1E, 1F, and 1G. With reference to FIG. 6, there is shown a schematic illustration of blind ultra violet (UV) photodetector **600** that includes a cathode **602,** one or more anodes **604A** and **604B,** the silicon base substrate layer **102,** the transition layer **104,** the gallium nitride buffer layer **106,** the p-doped gallium nitride layer **112,** and the gallium oxide layer **108.**

The blind ultra violet photodetector **600** is a semiconductor device, which is used for different applications, such as detection of ozone holes, detecting flame, space communication, missile guidance, biochemical detection, and inspection of ultra violet UV (leakage), and the like. The blind ultra violet photodetector **600** may also be referred to as a solar blind deep ultraviolet (DUV) photodetector.

The cathode **602** and one or more anodes **604A** and **604B** corresponds to terminals of the blind ultra violet photodetector **600,** which are used for further connectivity, such as to connect the blind ultra violet photodetector **600** to a power supply.

In accordance with an embodiment, the gallium oxide (Ga2O3) layer **108** is arranged to partially cover the p-doped gallium nitride (GaN) layer **112,** forming an exposed area of the p-doped gallium nitride (GaN) layer **112,** and wherein the member **100A** further comprises a cathode **602** formed on the gallium oxide (Ga2O3) layer **108** and one or more anodes **604A** and **604B** formed on the p-doped gallium nitride (GaN) layer **112.** In other words, the member **100A** includes the transition layer **104,** which is deposited on the silicon base substrate layer **102,** and the gallium nitride buffer layer **106,** which is deposited directly on the transition layer **104.** The member **100A** further includes the p-doped gallium nitride layer **112** arranged on the gallium nitride buffer layer **106.** Thereafter, the gallium oxide layer **108** is arranged on the p-doped gallium nitride layer **112,** such as to partially cover the p-doped gallium nitride layer **112.** In an example, the gallium oxide layer **108** is arranged at the center of the p-doped gallium nitride layer **112.** The member **100A** further includes the formation of the cathode **602** on the gallium oxide layer **108** and one or more anodes **604A** and **604B** on the p-doped gallium nitride layer **112.** In an implementation, the cathode **602** formed on the gallium oxide layer **108** is a light-sensitive cathode. Therefore, the member **100A** forms the blind ultra violet photodetector **600,** which is beneficial for different applications, such as detection of ozone holes, detecting flame, space communication, missile guidance, biochemical detection, and inspection of ultraviolet (UV) leakage, and the like.

FIG. 7 is a block diagram of a power device, in accordance with an embodiment of the present disclosure. FIG. 7 is described in conjunction with elements from FIGs. 1A, 1B, 1C, 1D, 1E, 1F, and 1G. With reference to FIG. 7, there is shown a block diagram **700** of a power device **702** that includes the member **100A.**

The power device **702** is a semiconductor device that is used as a switch or rectifier in power electronics, such as in an integrated circuit or a power integrated circuit. Examples of the power device **702** include but are not limited to a power metal-oxide-semiconductor field-effect transistor (MOSFET), a power diode, a thyristor, an insulated-gate bipolar transistor (IGBT), and the like.

The present disclosure provides a power device **702** comprising the member **100A.** By virtue of using the member **100A,** the power device **702** is beneficial for co-integration of ultra-wide-bandgap technology (e.g., by use of the gallium oxide (Ga2O3) layer **108** of FIG. 1A) with gallium nitride technology (i.e., gallium nitride buffer layer **106** of FIG. 1A) on cheap silicon substrates (i.e., the silicon base substrate layer **102** of FIG. 1A) of the member **100A.** Moreover, the power device **702** may include one of the members **100B, 100C, 100D, 100E, 100F,** and **100G** (of FIGs. 1B-1G, respectively). The power device **702** may also be referred to as an opto-electronic device.

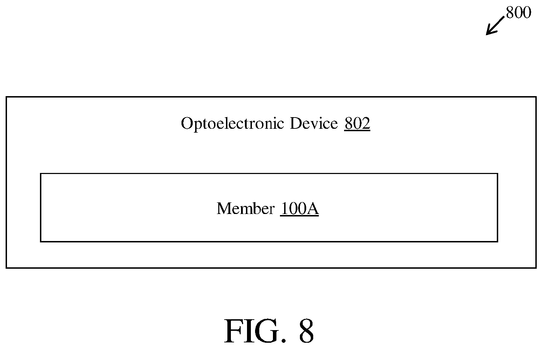

FIG. 8 is a block diagram of an optoelectronic device, in accordance with an embodiment of the present disclosure. FIG. 8 is described in conjunction with elements from FIGs. 1A, 1B, 1C, 1D, 1E, 1F, and 1G. With reference to FIG. 8, there is shown a block diagram **800** of an optoelectronic device **802** that includes the member **100A.**

The optoelectronic device **802** is an electronic device that may also be referred to as an electrical-to-optical or optical-to-electrical transducer. The optoelectronic device **802** provides an improved optical communication, and examples of the optoelectronic device **802** include but are not limited to light emitted diodes, laser diodes, photodiodes, solar cells, and the like.

The present disclosure provides an optoelectronic device **802** comprising the member **100A.** By virtue of using the member **100A,** the optoelectronic device **802** is beneficial for co-integration of ultra-wide-bandgap technology (e.g., by use of the gallium oxide (Ga2O3) layer **108** of FIG. 1A) with gallium nitride technology (i.e., gallium nitride buffer layer **106** of FIG.1A) on cheap silicon substrates (i.e., the silicon base substrate layer **102** of FIG.1A) of the member **100A.**

## Claims

1. A metal-semiconductor field-effect transistor, MESFET, device (300) comprising a member (100A, 100B, 100C, 100D, 100E, 100F, 100G), the member comprising:
a silicon base substrate layer (102);
a transition layer (104) arranged over the silicon base substrate layer (102);
a gallium nitride, GaN, buffer layer (106) arranged over the transition layer (104); and
a gallium oxide, Ga2O3, layer (108) deposited over the gallium nitride, GaN, buffer layer; wherein:
the gallium oxide, Ga2O3, layer comprises an n-doped gallium oxide, Ga2O3, layer (114) on top of a semi-insulating gallium oxide, Ga2O3, layer (302); and
the MESFET device further comprises a source node layer (304), gate node layer (306) and drain node layer (308) are arranged over the n-doped gallium oxide, Ga2O3, layer (114), wherein one ohmic contact (310A) is formed between the n-doped gallium oxide, Ga2O3, layer (114) and the source node layer (304), and one ohmic contact (310B) is formed between the n-doped gallium oxide, Ga2O3, layer (114) and the drain node layer (308).

2. The metal-semiconductor field-effect transistor, MESFET, device (300) according to claim 1, wherein the member (100A, 100B, 100C, 100D, 100E, 100F, 100G) further comprises a passivation layer (110) between the gallium nitride, GaN, buffer layer (106) and the gallium oxide, Ga2O3, layer (108), wherein the passivation layer (110) comprises aluminium oxide, silicon dioxide or silicon nitride.

3. The metal-semiconductor field-effect transistor, MESFET, device (300) according to claim 2, wherein the gallium oxide, Ga2O3, layer (108) is deposited on the gallium nitride, GaN, buffer layer (106) in an opening in the passivation layer (110).

4. The metal-semiconductor field-effect transistor, MESFET, device (300) according to claim 2, wherein the gallium oxide, Ga2O3, layer (108) is deposited over the gallium nitride, GaN, buffer layer (106), by being deposited on the passivation layer (110).

5. The metal-semiconductor field-effect transistor, MESFET, device (300) according to claim 1, wherein the member (100A, 100B, 100C, 100D, 100E, 100F, 100G) further comprises a p-doped gallium nitride, GaN, layer (112) arranged between the gallium nitride, GaN, buffer layer (106) and the gallium oxide, Ga2O3, layer (108).

6. The metal-semiconductor field-effect transistor, MESFET, device (300) according to any of claims 1 to 4, comprising a diode (404) wherein the member (100A, 100B, 100C, 100D, 100E, 100F, 100G) further comprises:
a second gallium oxide, Ga2O3, layer (406) with a p-doped gallium nitride, GaN, layer (112) being arranged under the second gallium oxide, Ga2O3, layer (406), wherein the second gallium oxide, Ga2O3, layer (406) is connected to the drain node layer (308) through a contact bridge (408A).

7. The metal-semiconductor field-effect transistor, MESFET, device (300) according to any of claims 1 to 4 comprising a diode (404), wherein the member (100A, 100B, 100C, 100D, 100E, 100F, 100G) further comprises:
a p-doped gallium nitride, GaN, layer (112) being arranged over the gallium nitride, GaN, buffer layer (106), wherein the p-doped gallium nitride, GaN, layer (112) is connected via an ohmic contact (410) to the source node layer (304) through a contact bridge (408B) and wherein the gallium nitride, GaN, buffer layer (106) is connected via an ohmic contact to the drain node layer (308) through a second contact bridge (412).

8. The metal-semiconductor field-effect transistor, MESFET, device (300) according to any preceding claim, wherein the member (100A, 100B, 100C, 100D, 100E, 100F, 100G) is further **characterized in that** the gallium nitride, GaN, buffer layer (106) comprises a aluminium gallium nitride, AlGaN, layer (416) on top of a gallium nitride, GaN, un-intentionally doped, UID, layer (414).

9. The metal-semiconductor field-effect transistor, MESFET, device (300) according to any preceding claim, wherein at least one of the ohmic contacts (310A, 310B, 410) comprises titanium and/or gold.

## Patentansprüche

1. Metall-Halbleiter-Feldeffekttransistor- bzw. MESFET-Vorrichtung (300), die ein Glied (100A, 100B, 100C, 100D, 100E, 100F, 100G) umfasst, wobei das Glied Folgendes umfasst:
eine Siliziumbasissubstratschicht (102);
eine Übergangsschicht (104), die über der Siliziumbasissubstratschicht (102) angeordnet ist;
eine Galliumnitrid- bzw. GaN-Pufferschicht (106), die über der Übergangsschicht (104) angeordnet ist; und
eine Galliumoxid- bzw. Ga2O3-Schicht (108), die über der Galliumnitrid- bzw. GaN-Pufferschicht aufgebracht ist; wobei:
die Galliumoxid- bzw. Ga2O3-Schicht eine n-dotierte Galliumoxid- bzw. Ga2O3-Schicht (114) auf einer halbisolierenden Galliumoxid- bzw. Ga2O3-Schicht (302) umfasst; und
die MESFET-Vorrichtung ferner eine Source-Knoten-Schicht (304), eine Gate-Knoten-Schicht (306) und eine Drain-Knoten-Schicht (308) umfasst, die über der n-dotierten Galliumoxid- bzw. Ga2O3-Schicht (114) angeordnet sind, wobei ein ohmscher Kontakt (310A) zwischen der n-dotierten Galliumoxid- bzw. Ga2O3-Schicht (114) und der Source-Knoten-Schicht (304) gebildet ist und ein ohmscher Kontakt (310B) zwischen der n-dotierten Galliumoxid- bzw. Ga2O3-Schicht (114) und der Drain-Knoten-Schicht (308) gebildet ist.

2. Metall-Halbleiter-Feldeffekttransistor- bzw. MESFET-Vorrichtung (300) nach Anspruch 1, wobei das Glied (100A, 100B, 100C, 100D, 100E, 100F, 100G) ferner eine Passivierungsschicht (110) zwischen der Galliumnitrid- bzw. GaN-Pufferschicht (106) und der Galliumoxid- bzw. Ga2O3-Schicht (108) umfasst, wobei die Passivierungsschicht (110) Aluminiumoxid, Siliziumoxid oder Siliziumnitrid umfasst.

3. Metall-Halbleiter-Feldeffekttransistor- bzw. MESFET-Vorrichtung (300) nach Anspruch 2, wobei die Galliumoxid- bzw. Ga2O3-Schicht (108) auf der Galliumnitrid- bzw. GaN-Pufferschicht (106) in einer Öffnung in der Passivierungsschicht (110) aufgebracht ist.

4. Metall-Halbleiter-Feldeffekttransistor -bzw. MESFET-Vorrichtung (300) nach Anspruch 2, wobei die Galliumoxid- bzw. Ga2O3-Schicht (108) über der Galliumnitrid- bzw. GaN-Pufferschicht (106) aufgebracht ist, indem sie auf der Passivierungsschicht (110) aufgebracht ist.

5. Metall-Halbleiter-Feldeffekttransistor- bzw. MESFET-Vorrichtung (300) nach Anspruch 1, wobei das Glied (100A, 100B, 100C, 100D, 100E, 100F, 100G) ferner eine p-dotierte Galliumnitrid- bzw. GaN-Schicht (112) umfasst, die zwischen der Galliumnitrid- bzw. GaN-Pufferschicht (106) und der Galliumoxid- bzw. Ga2O3-Schicht (108) aufgebracht ist.

6. Metall-Halbleiter-Feldeffekttransistor- bzw. MESFET-Vorrichtung (300) nach einem der Ansprüche 1 bis 4, die eine Diode (404) umfasst, wobei das Glied (100A, 100B, 100C, 100D, 100E, 100F, 100G) ferner Folgendes umfasst:
eine zweite Galliumoxid- bzw. Ga2O3-Schicht (406) mit einer p-dotierten Galliumnitrid- bzw. GaN-Schicht (112), die unter der zweiten Galliumoxid- bzw. Ga2O3-Schicht (406) angeordnet ist, wobei die zweite Galliumoxid- bzw. Ga2O3-Schicht (406) durch eine Kontaktbrücke (408A) mit der Drain-Knoten-Schicht (308) verbunden ist.

7. Metall-Halbleiter-Feldeffekttransistor- bzw. MESFET-Vorrichtung (300) nach einem der Ansprüche 1 bis 4, die eine Diode (404) umfasst, wobei das Glied (100A, 100B, 100C, 100D, 100E, 100F, 100G) ferner Folgendes umfasst:
eine p-dotierte Galliumnitrid- bzw. GaN-Schicht (112), die über der Galliumnitrid- bzw. GaN-Pufferschicht (106) angeordnet ist, wobei die p-dotierte Galliumnitrid- bzw. GaN-Schicht (112) über einen ohmschen Kontakt (410) durch eine Kontaktbrücke (408B) mit der Source-Knoten-Schicht (304) verbunden ist und wobei die Galliumnitrid- bzw. GaN-Pufferschicht (106) über einen ohmschen Kontakt durch eine zweite Kontaktbrücke (412) mit der Drain-Knoten-Schicht (308) verbunden ist.

8. Metall-Halbleiter-Feldeffekttransistor-bzw. MESFET-Vorrichtung (300) nach einem der vorhergehenden Ansprüche, wobei das Glied (100A, 100B, 100C, 100D, 100E, 100F, 100G) ferner **dadurch gekennzeichnet ist, dass** die Galliumnitrid- bzw. GaN-Pufferschicht (106) eine Aluminiumgalliumnitrid- bzw. AlGaN-Schicht (416) auf einer unbeabsichtigt dotierten Galliumnitrid- bzw. GaN-UID-Schicht (414) umfasst.

9. Metall-Halbleiter-Feldeffekttransistor- bzw. MESFET-Vorrichtung (300) nach einem der vorhergehenden Ansprüche, wobei mindestens einer der ohmschen Kontakte (310A, 310B, 410) Titan und/oder Gold umfasst.

## Revendications

1. Dispositif à transistor à effet de champ métal-semiconducteur, MESFET (300), comprenant un élément (100A, 100B, 100C, 100D, 100E, 100F, 100G), l'élément comprenant :
une couche de substrat de base en silicium (102) ;
une couche de transition (104) disposée sur la couche de substrat de base en silicium (102) ;
une couche tampon de nitrure de gallium, GaN, (106) disposée sur la couche de transition (104) ; et
une couche d'oxyde de gallium, Ga₂O₃, (108) déposée sur la couche tampon de nitrure de gallium, GaN ; dans lequel
la couche d'oxyde de gallium, Ga₂O₃, comprend une couche d'oxyde de gallium dopée n, Ga₂O₃, (114) au-dessus d'une couche d'oxyde de gallium semi-isolante, Ga₂O₃, (302) ; et
le dispositif MESFET comprend en outre une couche de nœud de source (304), une couche de nœud de grille (306) et une couche de nœud de drain (308) disposées sur la couche d'oxyde de gallium dopée n, Ga₂O₃, (114), un contact ohmique (310A) étant formé entre la couche d'oxyde de gallium dopée n, Ga₂O₃, (114) et la couche de nœud de source (304), et un contact ohmique (310B) étant formé entre la couche d'oxyde de gallium dopée n, Ga₂O₃, (114) et la couche de nœud de drain (308).

2. Dispositif à transistor à effet de champ métal-semiconducteur, MESFET, (300) selon la revendication 1, dans lequel l'élément (100A, 100B, 100C, 100D, 100E, 100F, 100G) comprend en outre une couche de passivation (110) entre la couche tampon de nitrure de gallium, GaN, (106) et la couche d'oxyde de gallium, Ga₂O₃, (108), la couche de passivation (110) comprenant de l'oxyde d'aluminium, du dioxyde de silicium ou du nitrure de silicium.

3. Dispositif à transistor à effet de champ métal-semiconducteur, MESFET, (300) selon la revendication 2, dans lequel la couche d'oxyde de gallium, Ga₂O₃, (108) est déposée sur la couche tampon de nitrure de gallium, GaN, (106) dans une ouverture pratiquée dans la couche de passivation (110).

4. Dispositif à transistor à effet de champ métal-semiconducteur, MESFET, (300) selon la revendication 2, dans lequel la couche d'oxyde de gallium, Ga₂O₃, (108) est déposée sur la couche tampon de nitrure de gallium, GaN, (106), en étant déposée sur la couche de passivation (110).

5. Dispositif à transistor à effet de champ métal-semiconducteur, MESFET, (300) selon la revendication 1, dans lequel l'élément (100A, 100B, 100C, 100D, 100E, 100F, 100G) comprend en outre une couche de nitrure de gallium dopée p, GaN, (112) disposée entre la couche tampon de nitrure de gallium, GaN, (106) et la couche d'oxyde de gallium, Ga₂O₃, (108).

6. Dispositif à transistor à effet de champ métal-semiconducteur, MESFET, (300) selon l'une quelconque des revendications 1 à 4, comprenant une diode (404), dans lequel l'élément (100A, 100B, 100C, 100D, 100E, 100F, 100G) comprend en outre :
une deuxième couche d'oxyde de gallium, Ga₂O₃, (406) avec une couche de nitrure de gallium dopée p, GaN, (112) disposée sous la deuxième couche d'oxyde de gallium, Ga₂O₃, (406), la deuxième couche d'oxyde de gallium, Ga₂O₃, (406) étant connectée à la couche de nœud de drain (308) par l'intermédiaire d'un pont de contact (408A).

7. Dispositif à transistor à effet de champ métal-semiconducteur, MESFET, (300) selon l'une quelconque des revendications 1 à 4, comprenant une diode (404), dans lequel l'élément (100A, 100B, 100C, 100D, 100E, 100F, 100G) comprend en outre :
une couche de nitrure de gallium dopée p, GaN, (112) disposée sur la couche tampon de nitrure de gallium, GaN, (106), la couche de nitrure de gallium dopée p, GaN, (112) étant connectée par l'intermédiaire d'un contact ohmique (410) à la couche de nœud de source (304) par l'intermédiaire d'un pont de contact (408B) et la couche tampon de nitrure de gallium, GaN, (106) étant connectée par l'intermédiaire d'un contact ohmique à la couche de nœud de drain (308) par l'intermédiaire d'un deuxième pont de contact (412).

8. Dispositif à transistor à effet de champ métal-semiconducteur, MESFET, (300) selon l'une quelconque des revendications précédentes, dans lequel l'élément (100A, 100B, 100C, 100D, 100E, 100F, 100G) est en outre **caractérisé en ce que** la couche tampon de nitrure de gallium, GaN, (106) comprend une couche de nitrure d'aluminium et de gallium, AlGaN, (416) au-dessus d'une couche de nitrure de gallium, GaN, dopée de manière non intentionnelle, UID, (414).

9. Dispositif à transistor à effet de champ métal-semiconducteur, MESFET, (300) selon l'une quelconque des revendications précédentes, dans lequel au moins l'un des contacts ohmiques (310A, 310B, 410) comprend du titane et/ou de l'or.
